# FASCICULE DE BREVET EUROPEEN

(11) **EP 1 615 042 B1**
(45) Date de publication et mention de la délivrance du brevet: **14.03.2012**
(21) Numéro de dépôt: 05291385.2
(22) Date de dépôt: 28.06.2005
(51) Int. Cl.: G01R 31/02

(54) **Procédé de vérification du cablage d'au moins un moteur électrique**
Verfahren zur Kabelüberprüfung zumindest eines elektrischen Motors
Checking method for cables of at least an electric motor

(30) Priorité: 05.07.2004 FR 0407429
(43) Date de publication de la demande: 11.01.2006
(73) Titulaire: Johnson Controls Technology Company, Holland, MI 49423 (US)
(72) Inventeur: Lagabe, Grégoire, 75017 Paris (FR)
(74) Mandataire: Lavialle, Bruno François Stéphane

(56) Documents cités:
- EP-A- 1 158 642
- DE-A1- 10 108 889
- US-A- 5 012 168
- US-A- 5 552 699

## Description

La présente invention concerne un procédé de vérification du câblage d'au moins un moteur électrique tel que les moteurs utilisés pour assurer le verrouillage et le déverrouillage des ouvrants d'un véhicule automobile équipé d'un système de verrouillage centralisé.

DE 10108889, EP1158642, US5012168 et US5552699 divulguent la vérification du câblage d'un moteur.

### ARRIERE PLAN DE L'INVENTION

Dans une telle application, les moteurs électriques sont montés dans les portières et le haillon du véhicule pour actionner les serrures de ceux-ci. Les moteurs électriques sont reliés chacun par un organe de commutation à un circuit d'alimentation lui-même relié à la batterie du véhicule. Les organes de commutation sont généralement reliés à un récepteur destiné à recevoir des signaux d'une télécommande.

Dans les opérations de contrôle de défauts réalisées lors de l'assemblage du véhicule, il est prévu de vérifier que les moteurs électriques assurent correctement leur fonction de verrouillage et de déverrouillage des ouvrants afin en particulier de déceler des erreurs de câblage des moteurs. Pour ce faire, un opérateur commande les organes de commutation vers un état de connexion pour que le moteurs actionnent les serrures pour verrouiller ou déverrouiller les ouvrants avant de tenter d'ouvrir manuellement les ouvrants pour vérifier que le verrouillage ou le déverrouillage a bien été effectué. Ce procédé d'essai est relativement long et peu pratique.

Il a été envisagé d'effectuer cet essai en mesurant l'intensité du courant circulant dans le circuit d'alimentation au moment où les organes de commutation sont commandés vers leur état de connexion. Toutefois, l'intensité mesurée à cet instant dépend du couple résistant que doit vaincre le moteur à son démarrage, ce couple résistant dépendant notamment de la serrure qu'actionne le moteur, et dépend également du moteur lui-même. Compte tenu des tolérances de fabrication des serrures et des moteurs, ce couple résistant varie d'une serrure à l'autre et d'un moteur à l'autre. Lorsqu'il y a plusieurs moteurs, il est donc difficile de déterminer à partir de l'intensité mesurée si tous les moteurs ont fonctionné correctement.

On pourrait commander successivement l'alimentation des moteurs et vérifier qu'à chaque alimentation correspond un pic d'intensité. Cependant, il serait alors relativement difficile de synchroniser la mesure avec le début de l'alimentation. En outre, un des moteurs pourrait arriver en butée (ce qui provoque un appel de courant) alors qu'un autre de ces moteurs n'a pas encore été alimenté, ce qui fausserait la mesure. Par ailleurs la mise en butée, de façon décalée, des moteurs provoque une succession bruits qui pourraient indisposer l'utilisateur.

### OBJET DE L'INVENTION

Il serait donc intéressant de disposer d'un moyen permettant de réaliser de manière fiable et rapide un essai de ces moteurs électriques.

### BREVE DESCRIPTION DE L'INVENTION

A cet effet, on prévoit, selon l'invention, un procédé de vérification d'un câblage d'au moins un moteur électrique associé à une butée de fin de course et relié à un circuit d'alimentation par au moins un organe de commutation sélectivement actionnable entre un état d'alimentation du moteur par le circuit et un état de non-alimentation du moteur, le procédé comprenant les étapes de :
- commander l'organe de commutation pour alimenter le moteur pendant un temps suffisant pour amener le moteur en butée,
- mesurer dans le circuit une intensité lorsque le moteur est en butée et comparer cette intensité et une intensité de référence.

Tant que le moteur est en butée, l' intensité est sensiblement constante de sorte que la réalisation d'une mesure ne pose pas de problèmes de synchronisation. En outre, cette intensité est maximale au cours de cette période et peut présenter une différence importante avec l'intensité de référence qui est par exemple celle du circuit lorsque le moteur n'est pas alimenté. Cette différence est alors aisément détectable.

Le procédé comprend les étapes de commander l'organe de commutation dans son état de non-alimentation et de mesurer dans le circuit une intensité lorsque le moteur n'est plus alimenté, l'intensité mesurée alors constituant l'intensité de référence.

Lorsque le moteur est en butée, l'intensité est maximale et la déconnexion du moteur provoque une baisse de courant suffisamment importante pour pouvoir être détectée de manière simple et fiable. Ainsi, il n'est pas recherché la mesure d'une valeur prédéterminée d'intensité mais une variation d'intensité entre, d'une part, l'intensité dans le circuit lorsque le moteur est alimenté et en butée et, d'autre part, l'intensité dans le circuit lorsque le moteur n'est plus alimenté.

Selon un mode de réalisation particulier, au moins deux moteurs étant chacun associé à une butée de fin de course et relié par un organe de commutation au circuit d'alimentation, les organes de commutation sont amenés vers leur état de non-alimentation de façon successive.

La coupure d'alimentation successive des moteurs provoque alors une succession de baisses d'intensité qu'il est aisé de compter pour déterminer si l'alimentation de tous les moteurs a été coupée.

Le moteur est considéré comme ayant un fonctionnement correct lorsque à la déconnexion correspond une baisse d'intensité supérieure à un seuil prédéterminé. Ainsi, on évite qu'une baisse temporaire d'intensité dans le circuit ne soit interprétée de façon erronée comme la coupure d'alimentation d'un moteur.

D'autres caractéristiques et avantages de l'invention ressortiront à la lecture de la description qui suit d'un mode de réalisation particulier non limitatif de l'invention.

### BREVE DESCRIPTION DES DESSINS

Il sera fait référence aux dessins annexés, parmi lesquels :
- la figure 1 est une représentation schématique d'une installation de verrouillage centralisé des ouvrants d'un véhicule automobile,
- la figure 2 est une vue schématique illustrant la courbe d'intensité dans le circuit d'alimentation lors d'une opération de verrouillage des ouvrants.

### DESCRIPTION DETAILLEE DE L'INVENTION

L'invention est ici décrite en application à une installation de verrouillage centralisé d'un véhicule automobile dont les ouvrants, c'est-à-dire les deux portières avant, les deux portières arrière et le haillon, sont pourvus d'une serrure 1, 2, 3, 4, 5 respectivement.

Chaque serrure est connue en elle-même et comprend un organe de verrouillage mobile entre une position de verrouillage dans laquelle l'organe de verrouillage est en butée et retient dans un logement de la serrure un élément fixe solidaire de la carrosserie du véhicule et une position de déverrouillage dans laquelle l'organe de verrouillage autorise le retrait de l'élément fixe hors du logement.

L'installation de verrouillage centralisé comprend des moteurs 6, 7, 8, 9, 10 reliés de manière connue en elle-même aux serrures 1, 2, 3, 4, 5 pour entraîner l'organe mobile de celle-ci entre ses deux positions.

Les moteurs 6 et 7 sont reliés par l'intermédiaire d'un organe de commutation 11 au circuit 100 d'alimentation électrique du véhicule. Les moteurs 8 et 9 sont reliés par un organe de commutation 12 au circuit 100 et le moteur 10 est relié par un organe de commutation 13 au circuit 100. Les moteurs 6, 7, 8, 9, 10 sont en outre reliés à un commun 101 du circuit 100 par un organe de commutation 14 et ont la même tension de référence (ici la masse). Les organes de commutation 11, 12, 13, 14 sont connus en eux-mêmes et possèdent deux états de connexion au circuit 100. La combinaison des états de connexion des organes de commutation 11, 12, 13 et des états de connexion de l'organe de commutation 14 permet de définir deux états d'alimentation de chaque moteur correspondant aux deux sens de rotation des moteurs et deux états de non-alimentation (mais un seul serait suffisant) dans lesquels les moteurs 6, 7, 8, 9, 10 ne sont pas alimentés (cette architecture est communément appelée pont en H).

Les organes de commutation 11, 12, 13 et 14 sont reliés à un module central de commande 15, connu en lui-même, qui est agencé pour commander les organes de commutation 11, 12, 13 et 14. Les moteurs 6 et 7 des serrures 1 et 2 des portières avant sont commandées simultanément, de même que les moteurs 8 et 9 de serrures 3 et 4 des portières arrière. Le moteur 10 de la serrure 5 du haillon peut être commandée indépendamment. Les moteurs 6, 7, 8, 9, 10 peuvent en outre être commandés simultanément.

Sur le commun 101 est monté en série un module de mesure d'intensité 102 et le circuit 100 est relié à la batterie 110 du véhicule.

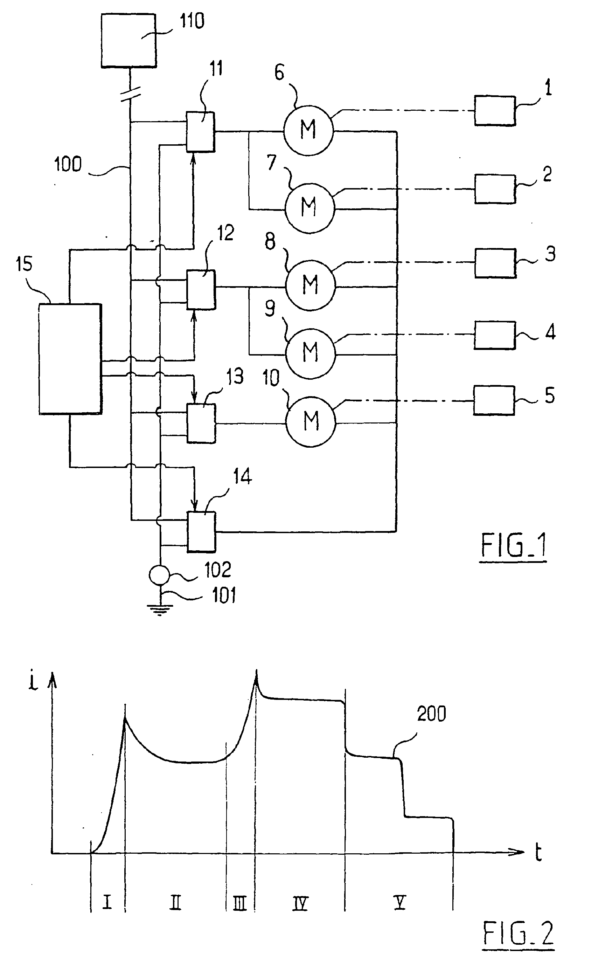

Le procédé de vérification conforme à l'invention va maintenant être décrit en référence à la figure 2 dont la courbe 200 représente l'intensité mesurée par le module de mesure 102 dans le commun 101 du circuit 100.

Le procédé de vérification sera ici décrit en relation avec une opération de verrouillage des serrures 1, 2, 3, 4, 5.

La première étape du procédé d'essai consiste à commander les organes de commutation 11, 12, 13, 14 vers leur état d'alimentation de manière que les moteurs 6, 7, 8, 9 et 10 entraînent les organes mobile de verrouillage des serrures 1, 2, 3, 4, 5 dans leur position de verrouillage.

Au démarrage, les moteurs doivent vaincre un couple résistant relativement important ; l'intensité croît alors rapidement (phase I).

Une fois les moteurs lancés, l'intensité décroît légèrement pour devenir stationnaire (phase II) jusqu'à augmenter à nouveau lorsque l'organe mobile arrive en butée (phase III). Lorsque l'organe mobile est en butée, les moteurs sont bloqués et l'intensité est sensiblement stationnaire (phase IV).

La commande de connexion est maintenue pendant un temps suffisant pour amener les moteurs en butée.

Pendant que les moteurs sont en butée, il est procédé à une mesure d'intensité dans le circuit (l'arrivée des moteurs en butée peut par exemple être estimé à partir du temps qui s'est écoulé depuis le début de l'alimentation du moteur en fonction de la durée nécessaire au moteur pour arriver en butée).

Une fois écoulé le temps de maintien de l'alimentation des moteurs, il est procédé à une étape dans laquelle les organes de commutation 11, 12, 13 sont commandés, de façon successive selon un espacement prédéterminé, pour couper l'alimentation des moteurs.

Après chaque coupure d'alimentation, l'intensité est mesurée dans le circuit par le module de mesure 102.

L'intensité mesurée après chaque coupure d'alimentation et l'intensité mesurée lorsque les moteurs sont en butée sont comparées.

La coupure d'alimentation des moteurs 6 et 7 va provoquer une baisse brutale de l'intensité qui sera suivie de deux nouvelles chutes d'intensité consécutives à la coupure d'alimentation des moteurs 8 et 9 puis du moteur 10 (phase V) .

L'absence d'une chute d'intensité après un ordre de coupure d'alimentation signifie que le ou les moteurs concernés par cet ordre n'ont pas fonctionné et ne sont donc pas correctement câblés (on suppose ici que les moteurs en eux-mêmes ne sont pas affectés par un dysfonctionnement).

Pour s'assurer que les moteurs 6, 7, 8, 9, 10 sont correctement câblés, il suffit donc de vérifier qu'un ordre de coupure de l'alimentation d'un moteur provoque une chute d'intensité. On considère ici que le bon fonctionnement des moteurs est vérifié si la chute d'intensité provoquée par leur coupure d'alimentation est supérieure à un seuil prédéterminé. A titre d'exemple, pour des moteurs 6 et 7 fonctionnant chacun à une intensité de trois ampères, le seuil prédéterminé sera égal à quatre ou cinq ampères environ. Il en sera de même pour les moteurs 8 et 9. Pour un moteur 10 fonctionnant à une intensité de trois ampères, la chute d'intensité devra au moins être égale à deux ampères. Ceci permet d'éviter que des chutes d'intensité temporaires ne résultant pas de la coupure de l'alimentation d'un moteur soient prises en compte.

On notera qu'il est sans importance que les moteurs soient déjà en butée en position de verrouillage au début du procédé de vérification.

Bien entendu, l'invention n'est pas limitée au mode de réalisation décrit et on peut y apporter des variantes de réalisation sans sortir du cadre de l'invention tel que défini par les revendications.

En particulier, le câblage des moteurs peut être différent de celui décrit. Par exemple, chacun des moteurs peut être raccordé au circuit 100 par l'intermédiaire d'un organe de commutation de telle manière que chaque moteur puisse être commandé de façon indépendante. De la même manière, le nombre de moteurs peut être différent de cinq. Le procédé de l'invention fonctionne également avec un seul moteur raccordé à un circuit comportant d'autres équipements. L'intensité de référence à laquelle est comparée l'intensité mesurée lorsque le moteur est en butée peut être une intensité du circuit dans une configuration donnée, par exemple avec tel ou tel équipement alimenté seulement. L'intensité dans le circuit peut être mesurée de façon continue ou seulement sur une période chevauchant la coupure d'alimentation.

Les polarités du circuit représenté à la figure 1 peuvent être inversées.

De plus, les organes de commutation peuvent être des interrupteurs classiques dans certaines applications ne nécessitant qu'un seul sens de rotation du moteur.

En outre, l'invention n'est pas limitée à l'application décrite mais peut être utilisé quel que soit l'élément entraîné.

## Revendications

1. Procédé de vérification d'un câblage d'au moins un moteur électrique (6, 7, 8, 9, 10) associé à une butée de fin de course et relié à un circuit d'alimentation (100) par au moins un organe de commutation (11, 12, 13, 14) sélectivement actionnable entre un état d'alimentation du moteur par le circuit et un état de non-alimentation du moteur, **caractérisé en ce qu'**il comprend les étapes de :
- commander l'organe de commutation pour alimenter le moteur pendant un temps suffisant pour amener le moteur en butée,
- mesurer dans le circuit une intensité lorsque le moteur est en butée et comparer cette intensité et une intensité de référence,
et **en ce que** le procédé comprend les étapes de commander l'organe de commutation dans son état de non-alimentation et de mesurer dans le circuit une intensité lorsque le moteur n'est plus alimenté, l'intensité mesurée alors constituant l'intensité de référence.

2. Procédé selon la revendication 1, au moins deux moteurs (6, 7, 8, 9, 10) chacun associé à une butée de fin de course et relié par un organe de commutation (11, 12, 13, 14) au circuit d'alimentation (100), **caractérisé en ce que** les organes de commutation sont amenés vers leur état de non-alimentation de façon successive.

3. Procédé de vérification d'un câblage d'au moins un moteur électrique (6, 7, 8, 9, 10) associé à une butée de fin de course et relié à un circuit d'alimentation (100) par au moins un organe de commutation (11, 12, 13, 14) sélectivement actionnable entre un état d'alimentation du moteur par le circuit et un état de non-alimentation du moteur, **caractérisé en ce qu'**il comprend les étapes de :
- commander l'organe de commutation pour alimenter le moteur pendant un temps suffisant pour amener le moteur en butée,
- mesurer dans le circuit une intensité lorsque le moteur est en butée et comparer cette intensité et une intensité de référence,
et **en ce que** le moteur (6, 7, 8, 9, 10) est considéré comme ayant un fonctionnement correct lorsque à la déconnexion correspond une baisse d'intensité supérieure à un seuil prédéterminé.

## Claims

1. Method for verifying the wiring of at least one electric motor (6, 7, 8, 9, 10) associated with an end of travel stop and connected to a power supply circuit (100) by at least one switching member (11, 12, 13, 14) adapted to be actuated selectively between a state in which the motor is supplied with power by said circuit and a state in which the motor is not supplied with power, **characterized in that** it comprises the steps of:
- commanding the switching member to supply the motor with power for sufficient time to move the motor to the stop; and
- measuring a current in the circuit when the motor is at the stop and comparing that current to a reference current;
and **in that** the method comprises the steps of commanding the switching member into its state of not supplying power and measuring a current in the circuit when the motor is no longer supplied with power, the measured current then constituting the reference current.

2. Method according to claim 1, at least two motors (6, 7, 8, 9, 10) each associated with an end of travel stop and connected by at least one switching member (11, 12, 13, 14) to the power supply circuit (100), **characterized in that** the switching members are brought to their state of not supplying power successively.

3. Method for verifying the wiring of at least one electric motor (6, 7, 8, 9, 10) associated with an end of travel stop and connected to a power supply circuit (100) by at least one switching member (11, 12, 13, 14) adapted to be actuated selectively between a state in which the motor is supplied with power by the circuit and a state in which the motor is not supplied with power, **characterized in that** it comprises the steps of:
- commanding the switching member to supply the motor with power for sufficient time to move the motor to the stop;
- measuring a current in the circuit when the motor is at the stop and comparing that current to a reference current;
and **in that** the motor (6, 7, 8, 9, 10) is considered to be operating correctly if disconnection corresponds to a reduction in current exceeding a predetermined threshold.

## Patentansprüche

1. Verfahren zur Überprüfung einer Verkabelung mindestens eines Elektromotors (6, 7, 8, 9, 10), der mit einem Endanschlag verbunden und an einen Versorgungskreis (100) über mindestens ein Schaltelement (11, 12, 13, 14) angeschlossen ist, das selektiv zwischen einem Zustand der Versorgung des Motors durch den Kreis und einem Zustand der Nicht-Versorgung des Motors betätigbar ist, **dadurch gekennzeichnet, dass** es die Schritte umfasst:
- Steuern des Schaltelements zum Versorgen des Motors über einen Zeitraum, der ausreicht, um den Motor zum Anschlag zu bringen,
- Messen einer Stromstärke in dem Kreis, wenn der Motor am Anschlag ist, und Vergleichen dieser Stromstärke mit einer Referenzstromstärke, und dass das Verfahren die Schritte des Steuerns des Schaltelements in seinen Zustand der Nicht-Versorgung und des Messens einer Stromstärke in dem Kreis umfasst, wenn der Motor nicht mehr versorgt wird, wobei die gemessene Stromstärke dann die Referenzstromstärke darstellt.

2. Verfahren nach Anspruch 1, wobei mindestens zwei Motoren (6, 7, 8, 9, 10) jeweils mit einem Endanschlag verbunden und über ein Schaltelement (11, 12, 13, 14) an den Versorgungskreis (100) angeschlossen sind, **dadurch gekennzeichnet, dass** die Schaltelemente nacheinander in ihren Zustand der Nicht-Versorgung gebracht werden.

3. Verfahren zur Überprüfung einer Verkabelung mindestens eines Elektromotors (6, 7, 8, 9, 10), der mit einem Endanschlag verbunden und an einen Versorgungskreis (100) über mindestens ein Schaltelement (11, 12, 13, 14) angeschlossen ist, das selektiv zwischen einem Zustand der Versorgung des Motors durch den Kreis und einem Zustand der Nicht-Versorgung des Motors betätigbar ist, **dadurch gekennzeichnet, dass** es die Schritte umfasst:
- Steuern des Schaltelements zum Versorgen des Motors über einen Zeitraum, der ausreicht, um den Motor zum Anschlag zu bringen,
- Messen einer Stromstärke in dem Kreis, wenn der Motor am Anschlag ist, und Vergleichen dieser Stromstärke mit einer Referenzstromstärke, und dass der Motor (6, 7, 8, 9, 10) als einwandfrei funktionierend angesehen wird, wenn der Abschaltung ein Stromstärkeabfall über einen vorgegebenen Schwellenwert entspricht,
